Europäisches Patentamt

European Patent Office

Office européen des brevets

(11) Publication number: **0 412 644 A2**

# EUROPEAN PATENT APPLICATION

(21) Application number: 90306886.4

(22) Date of filing: 22.06.90

(51) Int. Cl.5: **H01L 21/316, C23C 16/40**

(30) Priority: 08.08.89 US 391223

(43) Date of publication of application:
**13.02.91 Bulletin 91/07**

(84) Designated Contracting States:
**DE FR GB IT NL**

(71) Applicant: **APPLIED MATERIALS, INC.**
**3050 Bowers Avenue**
**Santa Clara California 95054(US)**

(72) Inventor: **Marks, Jeffrey**
**455 Crescent Avenue, No. 21**
**Sunnyvale, California 94087(US)**
Inventor: **Law, Kam Shing**
**443 Monaco Avenue**
**Union City, California 94587(US)**

(74) Representative: **Bayliss, Geoffrey Cyril et al**
**BOULT, WADE & TENNANT 27 Furnival Street**
**London EC4A 1PQ(GB)**

(54) Low temperature low pressure thermal CVD process for forming conformal group III and/or group V-doped silicate glass coating of uniform thickness on integrated structure.

(57) The disclosure relates to a low temperature low pressure process is disclosed for the formation of a layer of Group III and/or Group V-doped silicon oxide glass (30) of uniform thickness on a nonplanar surface of an integrated circuit structure (10) which comprises: flowing a gaseous mixture of a tetrethylorthosilicate (TEOS)-containing gas and an ozone ($O_3$)-containing gas in a volume ratio of 1:2 and a gaseous source of one or more Group III and/or Group V-containing dopants over an integrated circuit structure in a vacuum apparatus at a pressure of from about 20 to about 200 Torr, preferably from about 40 Torr to about 100 Torr, and a temperature of less than about 400° C to deposit a uniform thickness of Group III and/or Group V-doped silicon oxide glass on an integrated circuit structure.

FIG. 3

# LOW TEMPERATURE LOW PRESSURE THERMAL CVD PROCESS FOR FORMING CONFORMAL GROUP III AND/OR GROUP V-DOPED SILICATE GLASS COATING OF UNIFORM THICKNESS ON INTEGRATED CIRCUITE STRUCTURE

This invention relates to a process for forming a coating of uniform thickness on an integrated circuit structure. Our European Patent Application No. 87311193.4 relates to similar subject matter. More particularly, this invention relates to a low temperature low pressure thermal CVD process for forming a conformal Group III and/or Group V-doped silicon oxide coating of uniform thickness on an integrated circuit structure.

When an insulating layer of undoped glass, e.g., silicon oxide, is formed over an integrated circuit structure having a nonplanar surface because of the presence, for example, of raised protions such as metal or polysilicon lines, or recesses such as trenches, the silicon oxide glass tends to generally follow the contour of the nonplanar surface.

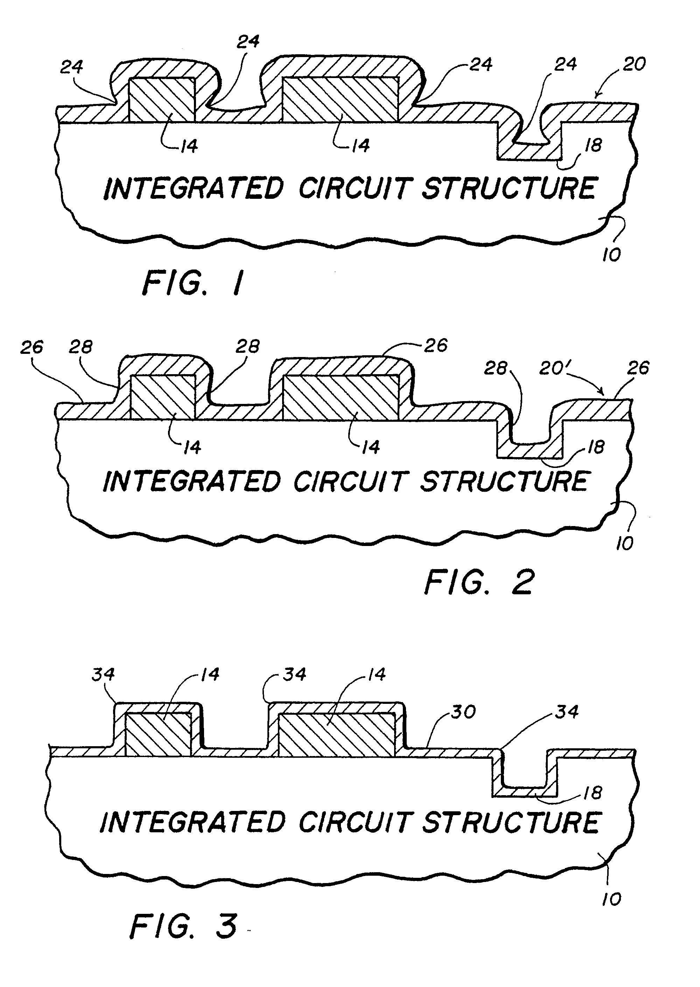

However, in a typical prior art structure, such as shown in Figure 1, the surface of an undoped silicon oxide coating 20 applied over a nonplanar integrated circuit structure 10 having raised portions 14 and recessed portions 18, tends to form a curved or undulating surface which curves downwardly and inwardly toward the sidewalls over low regions of the underlying structure and then curves back up and outwardly over high underlying portions of the underlying structure. This results in the formation of inverted corners 24 as shown in Figure 1. Thus, while such a coating can be generally said to be non-planar, as easily seen in Figure 1, it cannot be said to be a coating of uniform thickness.

Such siliccn oxide coatings may be deposited, for example, by plasma-assisted CVD processes such as a plasma-assisted doped tetraethylorthosilicate (TEOS) and oxygen ($O_2$) process or a plasma-assisted silane/$O_2$ process, at temperatures ranging from as high as 600°C when using silane ($SiH_4$) and oxygen ($O_2$) as the source gases to form silicon oxide, or as low as 390°C when using tetraethylorthosilicate (TEOS) and oxygen ($O_2$) as the source gases.

An undoped plasma-assisted TEOS/$O_2$ CVD process produces a somewhat more conformal oxide coating 20', as shown in Figure 2, but this prior art process also results in a non-uniform coating with the vertical surfaces of raised portions 14 and recessed portions 18 of integrated circuit structure 10 generally having a thinner oxide coating 28 formed thereon than the oxide ccating 26 formed over the horizontal surfaces.

After forming such layers of insulating material over such a nonplanar integrated circuit structure, a layer of glass doped with either boron or phosphorus or both is sometimes applied over the insulating glass layer to planarize the surface because of the lower melting or flow temperature of the doped glass which permits the structure to be heated sufficiently to cause the doped glass to flow without damaging the remainder of the structure by exposure to excessive heat, e.g., heated to a temperature of about 850°C. Conventionally, for planarization purposes, the doped glass is usually deposited at a temperature of about 400°C.

While the formation of a doped silicon oxide glass layer on an integrated circuit structure which will flow at low temperatures is desirable for planarization purposes, there are other applications where it would also be desirable to form a doped glass coating of uniform thickness on the surface of a nonplanar integrated circuit structure. Such a coating could be useful in trench doping, for providing sidewall spacers, or for trench filling after initially forming an insulating coating of undoped silicon oxide on the trench walls.

It has previously been proposed that such a coating of uniform thickness could be formed at atmospheric pressure using a gaseous mixture of tetraethylorthosilicate in a helium carrier gas and up to 1 wt.% of $O_3$ in an $O_2$ gas. It has also been proposed by K. Maeda to increase the concentration of the $O_3$ gas in the $O_2$ gas up to 4 wt.%, in an article entitled "Dielectric Film deposition by Atmospheric Pressure and Low Temperature CVD Using TEOS, Ozone, and New Organometallic Doping Sources", published in the 1989 Proceedings of the Sixth International IEEE VLSI Multilevel Interconnect Conference, at pp. 382-389.

However, we have found that such processes do not result in the formation of coatings having the desired uniform coating thicknesses, result in particle formation or presence on coated wafer, have low deposition rates (below about 2500 Angstroms/minute), result in coatings having high stress (greater than $3 \times 10^9$ dynes/cm$^2$), and the coating formed is not fully oxidized.

It is, therefore, an object of this invention to provide a low pressure process for the formation of a doped glass coating of uniform thickness on an integrated circuit structure.

It is another object of this invention to provide a low temperature low pressure process for the formation of a Group III and/or Group V-doped silicon oxide glass coating of uniform thickness on an integrated circuit structure.

It is yet another object of this invention to provide a low pressure process for the formation of a Group III and/or Group V-doped silicon oxide glass coating of uniform thickness on an integrated circuit structure at a deposition temperature of less than 400°C.

It is still another object of this invention to provide a low temperature low pressure process for the formation of a Group III and/or Group V-doped silicon oxide glass coating of uniform thickness on an integrated circuit structure which comprises flowing a mixture of (1) a tetraethylorthosilicate (TEOS)-containing gas and (2) an $O_3$-containing gas in a ratio of 1:2 and (3) a gaseous source of one or more Group III and/or Group V dopants over an integrated circuit structure at a temperature of less than 400°C in a vacuum deposition apparatus maintained at a vacuum of from about 20 to about 200 Torr.

It is still a further object of this invention to provide a Group III and/or Group V-doped silicon oxide glass coating of uniform thickness on an integrated circuit structure formed by flowing a mixture of (1) a TEOS-containing gas and (2) an $O_3$-containing gas in a ratio of 1:2 and (3) a gaseous source of one or more Group III and/or Group V dopants capable of reacting with TEOS and $O_3$ over an integrated circuit structure at a temperature of less than 400°C in a vacuum deposition apparatus maintained at a vacuum of from about 20 to about 200 Torr.

These and other objects of the invention will be apparent from the following description and accompanying drawings in which

Figure 1 is a fragmentary vertical cross-sectional view showing the formation of a prior art coating of silicon oxide over a non-planar integrated circuit structure utilizing either a plasma-assisted doped TEOS/$O_2$ CVD process or a plasma-assisted silane/$O_2$ process.

Figure 2 is a fragmentary vertical cross-sectional view showing the formation of another prior art coating of silicon oxide over a non-planar integrated circuit structure using a plasma-assisted undoped TEOS/$O_2$ process.

Figure 3 is a fragmentary vertical cross-sectional view showing the formation of a coating of doped silicon oxide of uniform thickness over a non-planar integrated circuit structure

Figure 4 is a flow sheet illustrating the process of the invention.

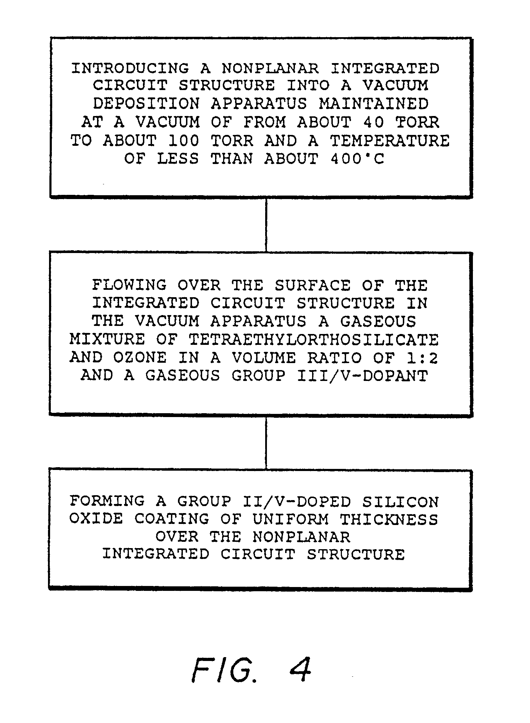

Referring now to Figures 3 and 4, a doped silicon oxide coating 30 of uniform thickness may be formed over a nonplanar integrated circuit structure 10 having one or more raised portions 14 and/or recessed portions 18 by a low temperature low pressure thermal CVD process which comprises flowing a gaseous mixture of (1) a TEOS-containing gas and (2) an $O_3$-containing gas in a ratio of 1:2 and (3) a gaseous source of one or more Group III and/or Group V dopants capable of reacting with both TEOS and $O_3$ over the surface of such an integrated circuit structure in a vacuum deposition apparatus maintained at a vacuum of from about 20 to about 200 Torr and at a temperature of less than about 400°C.

It will be noted that the coating of uniform thickness formed by this process, unlike the oxide coating with inverted corners 24 shown in Figure 1, is formed with corners 34 which are much more square due to the uniformity of the coating thickness of the process of the invention which produces the structure of Figure 3.

By use of the term "uniform coating" is meant a coating layer which does not vary by more than about 10% in thickness over the area on the integrated circuit structure on which the coating is deposited.

By use of the term "low temperature process" is meant a process wherein the uniform coating of doped silicon oxide is deposited at a temperature below about 500°C, preferably at a temperature ranging from about 380°C to about 450°C, and most preferably about 390°C.

By use of the term "low pressure process" is meant a process which is operable in a vacuum range of from about 20 Torr to about 200 Torr, preferably from about 40 Torr to about 100 Torr, which ensures that dust particles and other atmospheric pressure contaminants will be excluded from the process. It should be noted in this regard that when higher pressures are used, e.g., 400 Torr, the resultant coating thickness is not uniform.

By use of the term "thermal CVD" is meant a chemical vapor deposition process which is not plasma-assisted but which relies solely on thermal energy for the deposition.

The amount of flow into the vacuum chamber and over the integrated circuit structure of the carrier gas containing the TEOS may range from about 100 sccm to about 3000 sccm, preferably from about 500 sccm to about 1500 sccm. The carrier gas may comprise helium or argon or any other nonreactive gas which will not interfere with the reaction between the TEOS decomposition products, $O_3$, and the dopant. The concentration of the TEOS in the carrier gas may range from about 2 to about 6 mole percent of the TEOS/carrier gas mixture.

The flow rate of the $O_3$/$O_2$ gas may range from about 200 sccm to about 6000 sccm, and preferably ranges from about 1000 sccm to about 3000 sccm. The concentration of the $O_3$ in the $O_2$ gas ranges from at least 6 wt.% to about 10 wt.% of the $O_3$/$O_2$ mixture. Preferably the concentration of the $O_3$ gas in the $O_3$/$O_2$ mixture is at least about 8 wt.% to ensure sufficient oxidation of the coating.

The 1:2 ratio of TEOS to $O_3$, which is the ration of TEOS/carrier gas to $O_2/O_3$, is maintained at any of the flow rates.

The flow rate of the gaseous source of one or more Group III and/or Group V dopants, which is also mixed with a carrier gas such as helium or argon, may be varied from about 10 to about 100 sccm, depending upon the amount of dopant desired in the glass coating.

The optimal flow of the gaseous reactants to obtain the highest deposition rate will vary somewhat with the design and geometry of the particular vacuum apparatus utilized for the deposition process. If the flow rate is tco high, the deposition rate will be lowered because the residence time of the gas in the chamber is too short for reaction; while use of a low flow rate results in reaction and deposition of the doped glass elsewhere in the vacuum chamber than on the silicon wafer on which the integrated circuit structures have been formed.

For example, a flow rate of about 1000 sccm TEOS-containing gas, about 2000 sccm of the $O_3$-containing gas, and about 50 sccm of the gaseous source of one or more Group III and/or Group V dopants has been found to provide an optimal deposition rate of at least about 5000 Angstroms/minute using a deposition chamber in a 5000 Series vacuum apparatus available from Applied Materials, Inc.

The gaseous source of one or more Group III and/or Group V dopants, which is mixed with the TEOS and $O_3$ gases may comprise one or more of a number of Group III and/or Group V-containing compounds capable of decomposing to form a gas capable of reacting with both the TEOS and the $O_3$ in the specified pressure and temperature ranges of the process. By use of the terms "Group III and/or Group V-containing", Group III and/or Group V-doped" or "Group III and/or Group V dopant" is meant an arsenic, boron, or phosphorus-containing compound or mixtures thereof.

Examples of such Group III and/or Group V-containing compounds include triethylphosphine (TEP), trimethylphosphate (TMP), trimethylborate (TMB), (trimethylsilil)phosphate, (trimethylsilil)-borate, triethyl arsenic, and mixtures of same.

It should be noted that the Group III and/or Group V-containing dopants need not be organic compounds. However, the compound or compounds used must not be so reactive as to react with the $O_3$ before decomposition of the TEOS. Hence, the requirement that the compound be reactive with both the $O_3$ and the decomposition products of the TEOS. It has been found that Group III and/or Group V-containing organic compounds decompose sufficiently slow under the specified reaction conditions so as to permit the desired reaction with both the $O_3$ and the TEOS decomposition products.

The amount of the Group III and/or Group V dopant or dopants present in the gaseous source of Group III and/or Group V dopant ranges from about 2 to 100 wt.% of the dopant/carrier gas mixture with the balance comprising a suitable nonreactive carrier gas such as helium or argon. It should be noted here that for some volatile organic dopant sources, the use of a carrier gas is unnecessary.

To further illustrate the practice of the invention, a silicon wafer, having a pattern of polysilicon previously formed thereon, was placed in a vacuum depcsition chamber of an Applied Materials 5000 Series vacuum apparatus under a vacuum of about 45 Torr and a temperature of about 390°C. A mixture of gases was flowed over the wafer consisting of about 1000 sccm of TEOS (4 mole percent TEOS/balance helium), about 2000 sccm of $O_3$ (8 wt.% $O_3$/92 wt.% $O_2$), and about 20 sccm of Triethylphosphine (used without carrier gas) for about 2 minutes to deposit a phosphosilicate glass layer of uniform thickness on the patterned silicon wafer. The coated wafer was then removed from the apparatus, cross-sectioned, and examined under SEM to determine the uniformity of the coating deposition. A uniform coating of about 5000 Angstroms of phosphosilicate glass, having a maximum coating thickness variation of not over 10%, was observed to have been deposited.

Thus, the invention provides a coating of Group III and/or Group V-doped silicate glass of uniform thickness on an integrated circuit structure and a low pressure process for forming such a coating of uniform thickness.

**Claims**

1. A low temperature low pressure process for the formation of a layer of Group III and/or Group V-doped silicon oxide glass of uniform thickness on a nonplanar surface of an integrated circuit structure which comprises: flowing a gaseous mixture of a tetraethylorthosilicate (TEOS)-containing gas and an ozone ($O_3$)-containing gas in a volume ratio of 1:2 and a gaseous source containing one or more Group III and/or Group V dopants over an integrated circuit structure in a vacuum apparatus at a temperature of less than about 500°C.

2. The process of claim 1 wherein said low pressure in said vacuum apparatus ranges from about 20 to about 200 Torr.

3. The process of claim 2 wherein said low pressure in said vacuum apparatus ranges from about 40 to about 100 Torr.

4. The process of claim 3 wherein the amount of said TEOS-containing gas flowing over said integrated circuit structure ranges from about 100 sccm to about 3000 sccm.

5. The process of claim 3 wherein the amount of said ($O_3$)-containing gas flowing over said integrated circuit structure ranges from about 200 sccm to about 6000 sccm.

6. The process of claim 3 wherein the amount of said gaseous source of one or more Group III and/or Group V dopants flowing over said integrated circuit structure ranges from about 10 to about 100 sccm.

7. The process of claim 6 wherein said gaseous source of one or more Group III and/or Group V dopants comprises a compound selected from the class consisting of arsenic, boron, and phosphorus-containing compounds and mixtures of same.

8. The process of claim 3 wherein the temperature in said vacuum apparatus ranges from about 380° C to about 480° C.

9. A low temperature process for the formation of a layer of Group III and/or Group V-doped silicon oxide glass of uniform thickness with a maximum variation in thickness of not more than 10% on a nonplanar surface of an integrated circuit structure which comprises: flowing a gaseous mixture of flowing a gaseous mixture of from about 500 to about 1500 sccm of a tetraethylorthosilicate (TEOS)-containing gas and from about 1000 to about 3000 sccm of an ozone ($O_3$)-containing gas in a volume ratio of 1:2 and from about 10 to about 100 sccm of a gaseous source of one or more Group III and/or Group V dopants selected from the class consisting of arsenic-containing, boron-containing, and phosphorus-containing compounds and mixtures thereof over an integrated circuit structure in a vacuum apparatus maintained at a vacuum of from about 40 Torr to about 100 Torr and at a temperature of from about 380° C to about 395° C.

10. A layer of doped silicon oxide glass of uniform thickness with a maximum variation in thickness of not more than 10%, formed on a nonplanar surface of an integrated circuit structure by flowing a gaseous mixture of a tetraethylorthosilicate (TEOS)-containing gas and an ozone ($O_3$)-containing gas in a volume ratio of 1:2 and a gaseous source of one or more Group III and/or Group V-containing dopants over an integrated circuit structure over an integrated circuit structure in a vacuum apparatus at a temperature of less than about 500° C and a pressure of from about 20 Torr to about 200 Torr.

FIG. 1

FIG. 2

FIG. 3

INTRODUCING A NONPLANAR INTEGRATED
CIRCUIT STRUCTURE INTO A VACUUM
DEPOSITION APPARATUS MAINTAINED
AT A VACUUM OF FROM ABOUT 40 TORR
TO ABOUT 100 TORR AND A TEMPERATURE
OF LESS THAN ABOUT 400°C

FLOWING OVER THE SURFACE OF THE
INTEGRATED CIRCUIT STRUCTURE IN
THE VACUUM APPARATUS A GASEOUS
MIXTURE OF TETRAETHYLORTHOSILICATE
AND OZONE IN A VOLUME RATIO OF 1:2
AND A GASEOUS GROUP III/V-DOPANT

FORMING A GROUP II/V-DOPED SILICON
OXIDE COATING OF UNIFORM THICKNESS
OVER THE NONPLANAR
INTEGRATED CIRCUIT STRUCTURE

## FIG. 4